# EUROPÄISCHE PATENTSCHRIFT

(11) **EP 3 435 504 B1**
(45) Veröffentlichungstag und Bekanntmachung des Hinweises auf die Patenterteilung: **30.07.2025**
(21) Anmeldenummer: 18179958.6
(22) Anmeldetag: 26.06.2018
(51) Int. Cl.: H02H 3/17, H02H 7/12, G01R 27/18, H02H 3/16, G01R 31/12

(54) **VERFAHREN, ELEKTRISCHE SCHALTUNGSANORDNUNGEN UND ISOLATIONSÜBERWACHUNGSGERÄTE FÜR EINE STÖRRESISTENTE ISOLATIONSÜBERWACHUNG EINES UNGEERDETEN STROMVERSORGUNGSSYSTEMS MIT EINEM UMRICHTER**
METHOD, ELECTRICAL CIRCUIT ASSEMBLIES AND ISOLATION MONITORING DEVICES FOR INTERFERENCE-RESISTANT INSULATION MONITORING OF AN UNGROUNDED POWER SUPPLY SYSTEM UTILIZING A CONVERTER
PROCÉDÉ, ENSEMBLES DE CIRCUIT ÉLECTRIQUES ET APPAREILS DE SURVEILLANCE DE L'ISOLATION POUR UNE SURVEILLANCE D'ISOLATION RÉSISTANTE AU BROUILLAGE D'UN SYSTÈME D'ALIMENTATION ÉLECTRIQUE POURVU D'UN CONVERTISSEUR

(30) Priorität: 11.07.2017 DE 102017211845
(43) Veröffentlichungstag der Anmeldung: 30.01.2019
(60) Teilanmeldung: 23210103.0
(73) Patentinhaber: Bender GmbH & Co. KG, 35305 Grünberg (DE)
(72) Erfinder: HACKL, Dieter, 35463 Fernwald (DE)
(74) Vertreter: advotec.

(56) Entgegenhaltungen:
- EP-A1- 2 219 041
- EP-A1- 2 230 522
- EP-A2- 2 490 032

## Beschreibung

Die Erfindung betrifft ein Verfahren und eine elektrische Schaltungsanordnung für eine störresistente Isolationsüberwachung eines ungeerdeten Stromversorgungssystems mit einem Umrichter (Frequenzumrichter).

Weiterhin betrifft die Erfindung ein Isolationsüberwachungsgerät mit der vorgeschlagenen elektrischen Schaltungsanordnung.

Für die Versorgung von elektrischen Betriebsmitteln kommt bei erhöhten Anforderungen an die Betriebs-, Brand- und Berührungssicherheit die Netzform eines ungeerdeten (IT-) Stromversorgungssystems (frz. Isolé Terre) zum Einsatz. Bei dieser Art des Stromversorgungssystems sind alle aktiven Teile des versorgenden Netzes von dem Erdpotential getrennt.

Durch die inhärente Sicherheit des ungeerdeten Stromversorgungssystems gegenüber gefährlichen Berührungsspannungen kann somit eine kontinuierliche Stromversorgung der an das ungeerdete Stromversorgungssystem angeschlossenen Verbraucher auch dann aufrechterhalten werden, wenn ein erster Isolationsfehler auftritt.

Der elektrische Widerstand von aktiven Leitern des Stromversorgungssystems gegen Erde (Isolationswiderstand - im Fehlerfall auch Isolationsfehlerwiderstand oder Fehlerwiderstand) wird daher ständig überwacht, da durch einen möglichen weiteren Fehler an einem anderen aktiven Leiter (zweiter Fehler) eine Fehlerschleife entstünde und der dabei fließende Fehlerstrom in Verbindung mit einer Überstrom-Schutzeinrichtung eine Abschaltung der Anlage mit Betriebsstillstand zur Folge hätte.

In der Regel erfolgt die Überwachung des Isolationswiderstands durch ein Isolationsüberwachungsgerät (IMD - Insulation Monitoring Device), welches dem Stromversorgungssystem aktiv eine Messspannung überlagert und ein dem Isolationswiderstand entsprechendes Messsignal erfasst und auswertet.

Allerdings existieren in dem ungeerdeten Stromversorgungssystem Anwendungsfälle, beispielsweise im Bergbau oder in Kraftwerken, in denen auch bei Auftreten eines ersten Isolationsfehlers die Stromversorgung möglichst schnell abgeschaltet werden soll. Das Isolationsüberwachungsgerät sollte dann möglichst schnell einen ersten Fehler erkennen und ein Schaltsignal auslösen.

Die Forderung nach einer möglichst kurzen Abschaltzeit wird, anders als in einem geerdeten Stromversorgungssystem, nicht mit dem Ziel einer Vermeidung der Gefährdung durch elektrischen Schlag bestimmt - diese Gefährdung existiert in dem normgerecht installierten ungeerdeten Stromversorgungssystem definitionsgemäß im ersten Fehlerfall nicht -, sondern durch die Anforderungen im Hinblick auf den Brandschutz und den Anlagenschutz.

Insbesondere bei der Isolationsüberwachung in Verbindung mit hochwertigen (Frequenz-) Umrichtern und geregelten Antrieben wären mit einer aktiven Isolationsüberwachung kurze Abschaltzeiten im Bereich von einigen 10 s theoretisch möglich, da die Netzableitkapazitäten in diesen Antrieben häufig genügend kleine Werte aufweisen.

Praktisch sind diese Abschaltzeiten in vielen Umrichteranwendungen aber nicht erreichbar, da gerade durch den Umrichterantrieb (Umrichtergeregelter Elektromotormotor) applikationsbedingt niederfrequente Verlagerungsspannungen, d.h. Spannungen zwischen einem aktiven Leiter und Erde, mit einer Amplitude erzeugt werden, die häufig ein Vielfaches der Amplitude der von dem Isolationsüberwachungsgerät angelegten Messspannung beträgt und damit das erfasste Messsignal empfindlich stören können.

Liegt zudem die Frequenz der niederfrequenten Verlagerungsspannungsanteile sehr nahe bei der (Grund-) Frequenz (Messfrequenz) der angelegten und speziell getakteten Messspannung, so ist eine Überwachung in diesem Betriebszustand nicht möglich.

Herstellerübergreifend wird dem Störeinfluss durch niederfrequente Verlagerungsspannungsanteile in technischen Dokumentationen der Isolationsüberwachungsgeräte mit der Angabe einer (Überwachungs-) Lücke im spezifizierten Frequenzbereich Rechnung getragen. So ist beispielsweise der überwachbare Frequenzbereich bei einem dem Stand der Technik entsprechenden Isolationsüberwachungsgerät dahingehend spezifiziert, dass eine zuverlässige Isolationsüberwachung nur für Netzspannungen "DC und 15 bis 460 Hz" möglich ist, also eine Überwachungslücke zwischen DC (Gleichstrom) und 15 Hz existiert.

Aufgrund der niederfrequenten Störanteile in dem erfassten Messsignal gestaltet sich die Auswertung des erfassten Messsignals aufwändig und die nach dem Stand der Technik erreichbaren Abschaltzeiten sind deutlich höher, als dies in manchen kritischen Anwendungen (Bergbau, Kraftwerke) gefordert wird.

Extreme Anforderungen an die Abschaltzeiten treten insbesondere dann auf, wenn beispielsweise ein bestehendes 3AC 50/60 Hz IT-System mit sehr großen Netzableitkapazitäten mit einem leistungsstarken Frequenzumrichter-Antrieb erweitert wird. So können bei einem Erdschluss an einer Motorphase des geregelten Umrichterantriebs Verlagerungsspannungen entstehen, die zur Zerstörung von nicht dafür ausgelegten Betriebsmitteln im bestehenden 3AC 50/60 Hz IT-System führt. Hier werden oft Abschaltzeiten unter 100 ms gefordert.

Neben den in dieser Erfindung nicht weiterverfolgten niederfrequenten Störungen, die eine rechenintensive und zeitaufwändige Auswertung des erfassten Messsignals erfordern und damit eine Schnellabschaltung beeinträchtigen, treten in dieser Erfindung betrachtete, vom Umrichter erzeugte, schaltfrequente, d.h. der Schaltfrequenz des Umrichters entsprechende, Störanteile im Bereich von ca. 10 kHz oder darüber auf, die wegen ihrer beeinträchtigenden Wirkung auf die Betriebsmittel eine schnelle Abschaltung der Stromversorgung erforderlich machen.

Zur Isolationsüberwachung ist aus dem Stand der Technik bekannt, den Messspannungsanteil aus dem störungsbehafteten, erfassten Messsignal durch analoge oder digitale Filtermaßnahmen zu selektieren.

Die Offenlegungsschrift EP 2 230 522 A1 zeigt ein Verfahren und eine Vorrichtung zur Isolationsüberwachung eines Gleichstrom-IT-Netzes, das über einen galvanisch verbundenen Wechselrichter an ein geerdetes Wechselstromnetz gekoppelt ist. Zur Bestimmung des Isolationswiderstands ist eine Widerstandsmesseinrichtung vorgesehen, die über einen Umschalter einen Referenzwiderstand wechselweise mit den Leitern des Gleichstrom-IT-Netzes verbindet. Als besonderes Merkmal kann mit einer zusätzlichen Strommesseinrichtung auf der Gleichstromseite ein über den laufenden Wechselrichter fließender Ableitstrom detektiert werden.

In EP 2 490 032 A2 ist ein Verfahren zur Erkennung von Erdschlüssen in einem Motorantriebssystem mit einem Umrichter offenbart. Dabei wird das Antriebssystem mit einer Gleichtaktspannung (common mode voltage - CMV) beaufschlagt, um Motorsteuersignale zu erzeugen, die eine eindeutige Identifizierung von Fehlerströmen ermöglichen
In der Regel kommen in hochwertigen Isolationsüberwachungsgeräten aufwändige Methoden der digitalen Signalverarbeitung zum Einsatz, um Störkomponenten zu unterdrücken, deren Frequenz sehr nahe bei der Messfrequenz liegt. Je näher die Störsignalfrequenz bei der Messfrequenz liegt, umso mehr Rechenaufwand und Verarbeitungszeit wird für eine ausreichende Störsignalunterdrückung benötigt.

Ein in geerdeten - im Vergleich zu den hier betrachteten ungeerdeten - Stromversorgungssystemen verfolgter Ansatz, eine Schnellabschaltung von Anlagenteilen im Fall eines kritischen Fehlers zu realisieren, besteht darin, Differenzstrom-basierte Schutzeinrichtungen (Fehlerstrom-Schutzeinrichtungen RCD - Residual Current Protective Device) zu verwenden.

Bei Anwendungen mit leistungsstarken Frequenzumrichterantrieben ist jedoch in dem besonders kritischen Fehlerfall, dem Erdschluss einer Motorphase, mit großen Gleichstromanteilen in dem Fehlerstrom zu rechnen. Der Einsatz einer Fehlerstrom-Schutzeinrichtung Typ A (zur Erkennung von Fehlerwechselströmen und pulsierenden Fehlergleichströmen) ist somit meist nicht möglich. Entsprechende geeignete Fehlerstrom-Schutzeinrichtungen Typ B (zur Erkennung von Fehlerwechselströmen, pulsierenden Fehlergleichströmen und reinen Fehlergleichströmen) für leistungsstarke Frequenzumrichterantriebe sind häufig nicht verfügbar.

Allerdings ist der Einsatz von Differenzstrom-basierten Schutzeinrichtungen in ungeerdeten Stromversorgungssystemen grundsätzlich problematisch, da diese Art der Schutzeinrichtung nur zuverlässig funktioniert, wenn sichergestellt ist, dass sich der Differenzstromwandler der Fehlerstrom-Schutzeinrichtung auch tatsächlich in der Fehlerschleife befindet.

Die Forderung nach kurzen Mess- und Abschaltzeiten, die in speziellen Anwendungsfällen geboten ist, kann nach dem Stand der Technik nicht vollumfänglich erfüllt werden.

Der vorliegenden Erfindung liegt somit die Aufgabe zu Grunde, ein Verfahren und eine Vorrichtung für eine störresistente Isolationsüberwachung in einem ungeerdeten Stromversorgungssystem mit einem Umrichterantrieb anzugeben.

Diese Aufgabe wird bezogen auf ein Verfahren in Verbindung mit dem Oberbegriff des Anspruchs 1 durch die kennzeichnenden Merkmale des Anspruchs 1 gelöst.

Im Unterschied zu den aus dem Stand der Technik bekannten Verfahren, die auf einer Selektion des Messspannungsanteils aus dem störungsbehafteten, erfassten Messsignal beruhen, basiert die erfindungsgemäße Lösung darauf, die von dem Umrichter erzeugten schaltfrequenten Signalanteile unabhängig von der Erfassung des Messsignals zu erkennen, zu bewerten und gegebenenfalls daraus ein (Ab-) Schaltsignal abzuleiten.

Mittels einer Ankopplungseinrichtung wird eine Messspannung zwischen einen - in mehrphasigen ungeerdeten Stromversorgungssystemen vorzugsweise zwischen allen - aktiven Leiter(n) des Stromversorgungssystems und Erde angelegt. Die dem Stromversorgungssystem überlagerte Messspannung erzeugt ein Messsignal, welches in der Ankopplungseinrichtung erfasst und zur Bestimmung des Isolationswiderstands des Stromversorgungssystems und gegebenenfalls zur Abschaltung fehlerhafter Anlagenteile herangezogen wird. Ein unverfälschtes Messsignal ist daher unerlässlich.

Im Falle eines unsymmetrischen, sehr niederohmigen Erdschlusses an einer Motorphase (aktiven Leiter) des Umrichterantriebs verursacht der Umrichter eine schaltfrequente Gleichtaktspannung, die sich auf der Eingangsseite des Umrichters (netzseitig) als Verlagerungsspannung zwischen dem betroffenen aktiven Leiter des Stromversorgungssystem und Erde bemerkbar macht und eine Amplitude aufweist, die etwa der Zwischenkreisspannung des Frequenzumrichters entspricht.

Sind in dem ungeerdeten Stromversorgungssystem netzseitig des Frequenzumrichters sehr große Netzableitkapazitäten vorhanden - der kapazitive Leitwert ist proportional zur Kapazität und zur Frequenz -, so bewirken vor allem diese schaltfrequenten Anteile der Verlagerungsspannung einen hohen, potentiell gefährlichen Strom über eine Erdverbindung, z.B. einen Schutzleiter der angeschlossenen Verbraucher.

Zur Erkennung des schaltfrequenten Signalanteils wird daher die Verlagerungsspannung zwischen dem betroffenen aktiven Leiter des Stromversorgungssystems und Erde auf der Eingangsseite des Umrichters erfasst. In mehrphasigen ungeerdeten Stromversorgungssystemen erfolgt diese Erfassung der Verlagerungsspannung vorzugsweise zwischen allen aktiven Leitern und Erde.

Mittels einer Filterschaltung wird der schaltfrequente Signalanteil aus der/den erfassten Verlagerungsspannung(en) zunächst herausgefiltert und anschließend ausgewertet. Falls die Auswertung ergibt, dass der schaltfrequente Signalanteil einen kritischen Amplitudenwert überschreitet, erfolgt die Auslösung eines Schaltsignals.

Die Filterung und Auswertung des schaltfrequenten Signalanteils aus der erfassten Verlagerungsspannung ist erfindungsgemäß so ausgelegt, dass netzfrequente Anteile und/oder Gleichanteile in der Verlagerungsspannung nicht zur Auslösung eines Schaltsignals bzw. nicht zur Abschaltung des fehlerhaften Umrichterantriebs führen.

Im Gegensatz zu dem beschriebenen Fehlerfall an einer Motorphase des Umrichterantriebs ("hinter" dem Umrichter) führt ein erster Fehler auf der netzfrequenten Seite des ungeerdeten Stromversorgungssystems ("vor" dem Umrichter) oder in einem Gleichspannungskreis des Umrichters auch bei sehr großen Netzableitkapazitäten zu deutlich kleineren Strömen. Bei Einhaltung der Vorgaben aus Normen zur Errichtung elektrischer Anlagen bewirken diese Ströme keine Zerstörung von Anlagenteilen. Eine schnelle Abschaltung ist in diesem Fall, wie bei einem ungeerdeten Stromversorgungssystem üblicherweise zu erwarten, nicht erforderlich.

Vorzugsweise erfolgt ein Trennen des Umrichters von dem Stromversorgungssystem, falls das Schaltsignal ausgelöst wird.

Erfindungsgemäß wird also eine Störresistenz bei der Isolationsüberwachung dadurch erzielt, dass schaltfrequente Signalanteile, die das zur Überwachung des Isolationswiderstands erfasste Messsignal verfälschen könnten, unabhängig von dem erfassten Messsignal erkannt und ausgewertet werden.

Die von dem Umrichter erzeugten, störenden, schaltfrequenten Signalanteile in der Verlagerungsspannung werden herausgefiltert, bewertet und bei Überschreiten eines kritischen Amplitudenwertes dieser schaltfrequenten Signalanteile ein Schaltsignal ausgelöst.

Das Schaltsignal kann zur schnellen selektiven Abschaltung des Frequenzumrichterantriebes genutzt werden. Damit ist eine selektive Schnellabschaltung eines fehlerhaften Umrichterantriebs bei Auftreten eines unsymmetrischen Erdschlusses möglich.

Eine Abschaltung weiterer Teile des Stromversorgungssystems "vor" dem Umrichter (netzseitig) ist nicht erforderlich. Für alle sonstigen angeschlossenen Verbraucher - außer für den fehlerhaften Umrichterantrieb - gelten daher weiterhin die Vorteile des ungeerdeten Stromversorgungssystems - sie können ungestört weiterbetrieben werden.

Bezogen auf eine Vorrichtung wird die der Erfindung zugrunde liegende Aufgabe in Verbindung mit dem Oberbegriff des Anspruchs 3 durch die kennzeichnenden Merkmale des Anspruchs 3 gelöst.

Zur Ausführung des erfindungsgemäßen Verfahrens nach Anspruch 1 weist die erfindungsgemäße elektrische Schaltungsanordnung als wesentliche Funktionsblöcke eine Ankopplungseinrichtung zum Anlegen der Messspannung, eine Erfassungseinrichtung zum Erfassen der Verlagerungsspannung und zum Herausfiltern des von dem Umrichter erzeugten schaltfrequenten Signalanteils sowie eine Auswertungsschaltung zum Auswerten des herausgefilterten, schaltfrequenten Signalanteils und zum Auslösen eines Schaltsignals auf.

Die Erfassungseinrichtung ist als analoge RC-Hochpass-Filterschaltung ausgebildet oder weist zum Herausfiltern des schaltfrequenten Signalanteils eine digitale Signal-verarbeitende Schaltung auf.

Diese digitale Filterschaltung kann vorteilhafterweise zusammen mit der Auswertungsschaltung in einem Isolationsüberwachungsgerät integriert werden.

**In** weiterer Ausgestaltung weist die elektrische Schaltungsanordnung eine Trennvorrichtung auf, die über eine Signalleitung zur Fortleitung des Schaltsignals mit der Auswertungsschaltung verbunden ist.

Falls von der Auswertungsschaltung ein Schaltsignal ausgelöst und über die Signalleitung an die Trennvorrichtung weitergeleitet wird, erfolgt eine Trennung des Umrichters von dem Stromversorgungsnetz.

Mit Vorteil umfasst das Isolationsüberwachungsgerät zur Überwachung eines Isolationswiderstands in einem ungeerdeten Stromversorgungssystem mit einem Umrichter eine erfindungsgemäße elektrische Schaltungsanordnung für eine störresistente Isolationsüberwachung, welche den von dem Umrichter erzeugten schaltfrequenten Signalanteil extrahiert und auswertet. Das zur Isolationsüberwachung vorgeschriebene und normgemäß ausgeführte Isolationsüberwachungsgerät kann durch eine Erweiterung mit der erfindungsgemäßen elektrischen Schaltungsanordnung unempfindlicher gegenüber schaltfrequenten Störanteilen gestaltet und mit einer Abschaltfunktion versehen werden.

Weitere vorteilhafte Ausgestaltungsmerkmale ergeben sich aus der nachfolgenden Beschreibung und den Zeichnungen, die bevorzugte Ausführungsformen der Erfindung an Hand von Beispielen erläutern. Es zeigt:

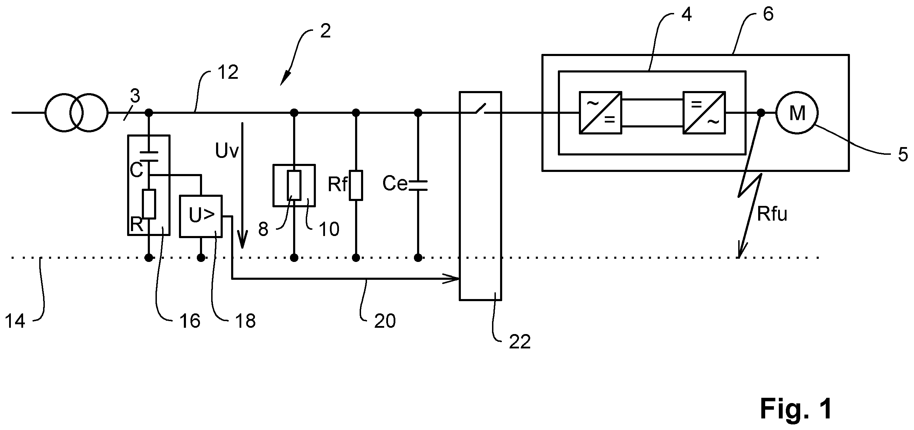

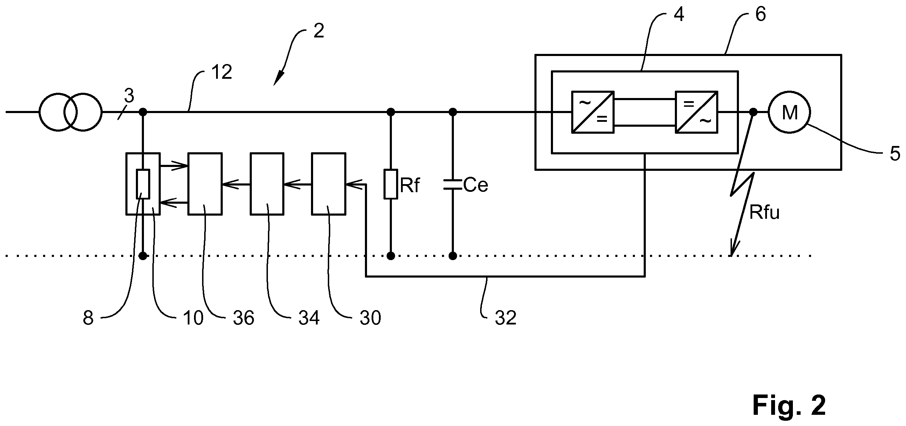

- **Fig. 1**:: eine Ausführungsform einer erfindungsgemäßen Schaltungsanordnung mit Auswertung eines schaltfrequenten Signalanteils.

**Fig.** 1 zeigt in einem funktionalen Blockdiagramm eine erste erfindungsgemäße Schaltungsanordnung für eine störresistente Isolationsüberwachung eines ungeerdeten Stromversorgungssystems 2 mit einem Umrichter 4. Der Umrichter 4 steuert einen Elektromotor 5 an und bildet zusammen mit diesem einen Umrichterantrieb 6.

Diese erfindungsgemäße Schaltungsanordnung beruht auf der Auswertung eines schaltfrequenten Signalanteils, um bei Auftreten eines Isolationsfehlers Rfu, beispielsweise bei einem Erdschluss an dem dem Umrichter 4 nachgeschalteten Elektromotor 5 (Antriebseinheit) den Umrichterantrieb 6 von dem Stromversorgungssystem 2 zu trennen.

Das ungeerdete Stromversorgungssystem 2 ist vorliegend 3-phasig ausgeführt und durch den Ableitwiderstand (Isolationswiderstand) Rf und die Ableitkapazität Ce charakterisiert.

Die erfindungsgemäße Schaltungsanordnung umfasst eine Ankopplungseinrichtung 8, die vorzugsweise in einem Isolationsüberwachungsgerät 10 angeordnet ist. Die Ankopplungseinrichtung 8 legt eine Messspannung zwischen mindestens einen aktiven Leiter 12 des Stromversorgungssystems 2 und Erde 14 an und erfasst ein von der Messspannung getriebenes Messsignal.

Weiterhin umfasst die erfindungsgemäße Schaltungsanordnung eine Erfassungseinrichtung 16, um eine zwischen dem aktiven Leiter 12 des Stromversorgungssystems 2 und Erde 14 vorhandene Verlagerungsspannung Uv zu erfassen - in mehrphasigen ungeerdeten Stromversorgungssystemen 2 werden die Verlagerungsspannungen Uv zwischen allen aktiven Leitern 12 und Erde 14 erfasst. Von dem Umrichter infolge des Erdschlusses Rfu erzeugte schaltfrequente Signalanteile werden in der Erfassungseinrichtung 16 aus der/den erfassten Verlagerungsspannung(en) Uv herausgefiltert.

Dargestellt ist die Erfassungseinrichtung 16 in einer Ausführung als analoge RC-Hochpassschaltung, alternativ ist auch eine Implementierung als digitale Filterstruktur möglich.

Der über dem Widerstand R der Erfassungseinrichtung 16 abgegriffene hoch- bzw. schaltfrequente Signalanteil wird einer Auswertungsschaltung 18 zugeführt, die ein Schaltsignal auslöst, falls das Auswerten des schaltfrequenten Signalanteils ergibt, dass dieser Signalanteil einen kritischen Amplitudenwert überschreitet. Die Auswertungsschaltung 18 kann beispielsweise als Überspannungsrelais ausgeführt sein.

Das Schaltsignal wird über eine Signalleitung 20 an eine Trennvorrichtung 22 weitergeleitet, die den fehlerhaften Umrichterantrieb 6 von dem Stromversorgungssystem 2 trennt.

## Patentansprüche

1. Verfahren für eine störresistente Isolationsüberwachung eines ungeerdeten Stromversorgungssystems (2) mit einem Umrichter (4) , umfassend die Verfahrensschritte:
Anlegen und aktives Überlagern einer Messspannung mittels einer Ankopplungseinrichtung (8) zwischen einen aktiven Leiter (12) des Stromversorgungssystems (2) und Erde (14) und Erfassen eines von der Messspannung getriebenen Messsignals zur Bestimmung eines Isolationswiderstands des Stromversorgungssystems (2),
**gekennzeichnet durch**
Erfassen einer Verlagerungsspannung mittels einer Erfassungseinrichtung (16) zwischen dem aktiven Leiter (12) oder einem anderen aktiven Leiter des Stromversorgungssystems (2) und Erde (14) auf einer Eingangsseite des Umrichters (4),
Herausfiltern eines von dem Umrichter (4) erzeugten schaltfrequenten Signalanteils aus der erfassten Verlagerungsspannung mittels einer analogen RC-Hochpass-Filterschaltung oder einer digitalen Signal-verarbeitenden Schaltung,
Auswerten des herausgefilterten, schaltfrequenten Signalanteils,
Auslösen eines Schaltsignals, falls das Auswerten des schaltfrequenten Signalanteils ergibt, dass der schaltfrequente Signalanteil einen kritischen Amplitudenwert überschreitet.

2. Verfahren nach Anspruch 1,
**gekennzeichnet durch**
Trennen des Umrichters (4) von dem Stromversorgungssystem (2), falls das Schaltsignal ausgelöst wird.

3. Elektrische Schaltungsanordnung für eine störresistente Isolationsüberwachung eines ungeerdeten Stromversorgungssystems (2) mit einem Umrichter (4),
mit einer Ankopplungseinrichtung (8) zum Anlegen einer Messspannung zwischen einen aktiven Leiter (12) des Stromversorgungssystems (2) und Erde (14) und zur Erfassung eines von der Messspannung getriebenen Messsignals zur Bestimmung eines Isolationswiderstands des Stromversorgungssystems (2),
**gekennzeichnet durch**
eine Erfassungseinrichtung (16) zum Erfassen einer Verlagerungsspannung zwischen dem aktiven Leiter (12) oder einem anderen aktiven Leiter des Stromversorgungssystems (2) und Erde (14) auf einer Eingangsseite des Umrichters (4) und zum Herausfiltern eines von dem Umrichter (4) erzeugten schaltfrequenten Signalanteils aus der erfassten Verlagerungsspannung und durch eine Auswertungsschaltung (18) zum Auswerten des herausgefilterten, schaltfrequenten Signalanteils und zum Auslösen eines Schaltsignals, falls das Auswerten des schaltfrequenten Signalanteils ergibt, dass der schaltfrequente Signalanteil einen kritischen Amplitudenwert überschreitet, wobei die Erfassungseinrichtung (16) als analoge RC-Hochpass-Filterschaltung ausgebildet ist oder zum Herausfiltern des schaltfrequenten Signalanteils eine digitale Signal-verarbeitende Schaltung aufweist.

4. Elektrische Schaltungsanordnung nach Anspruch 3,
**gekennzeichnet durch**
eine Trennvorrichtung (22), die über eine Signalleitung (20) zur Fortleitung des Schaltsignals mit der Auswertungsschaltung (18) verbunden ist.

5. Isolationsüberwachungsgerät zur Überwachung eines Isolationswiderstands in einem ungeerdeten Stromversorgungssystem (2) mit einem Umrichter (4),
**gekennzeichnet durch**
eine elektrische Schaltungsanordnung für eine störresistente Isolationsüberwachung nach Anspruch 3 oder 4.

## Claims

1. A method for an interference-resistant insulation monitoring of an ungrounded power supply system (2) having a converter (4), comprising the method steps:
applying and actively superimposing a measuring voltage between an active conductor (12) of the power supply system (2) and
ground (14) by means of a coupling device (8) and detecting a measuring signal driven by the measuring voltage to determine an insulation resistance of the power supply system (2),
**characterized by**
detecting a displacement voltage between the active conductor (12) or a different active conductor of the power supply system (2) and ground (14) on an input side of the converter (4) by means of a detection device (16),
filtering a switching-frequent signal portion, which is generated by the converter (4), from the detected displacement voltage by means of an analogous RC high-pass filter circuit or a digital signal processing circuit,
evaluating the filtered, switching-frequent signal portion,
triggering a switching signal should the evaluation of the switching-frequent signal portion yield that the switching-frequent signal portion surmounts a critical amplitude value.

2. The method according to claim 1,
**characterized by**
separating the converter (4) from the power supply system (2) should the switching signal be triggered.

3. An electrical circuit arrangement for an interference-resistant insulation monitoring of an ungrounded power supply system (2) having a converter (4),
having a coupling device (8) for applying a measuring voltage between an active conductor (12) of the power supply system (2) and ground (14) and for detecting a measuring signal driven by the measuring voltage to determine an insulation resistance of the power supply system (2),
**characterized by**
a detection device (16) for detecting a displacement voltage between the active conductor (12) or a different active conductor of the power supply system (2) and ground (14) on an input side of the converter (4) and for filtering a switching-frequent signal portion, which is generated by the converter (4), from the detected displacement voltage; and by an evaluation circuit (18) for evaluating the filtered switching-frequent signal portion and for triggering a switching signal should the evaluation of the switching-frequent signal portion yield that the switching-frequent signal portion surmounts a critical amplitude value, the detection device (16) being realized as an analogous RC high-pass filter circuit or having a digital signal processing circuit for filtering the switching-frequent signal portion.

4. The electrical circuit arrangement according to claim 3,
**characterized by**
a separating device (22) connected to the evaluation circuit (18) via a signal line (20) for forwarding the switching signal.

5. An insulation monitoring device for monitoring an insulation resistance in an ungrounded power supply system (2) having a converter (4),
**characterized by**
an electrical circuit arrangement for an interference-resistant insulation monitoring according to claim 3 or 4.

## Revendications

1. Procédé de surveillance d'isolement résistant aux interférences d'un système (2) d'alimentation en courant non mis à la terre ayant un convertisseur (4), comprenant les étapes du procédé :
l'application et la superposition active d'une tension de mesure entre un conducteur (12) actif du système (2) d'alimentation en courant et la terre (14) au moyen d'un dispositif de couplage (8) et
la détection d'un signal de mesure entraîné par la tension de mesure pour déterminer une résistance d'isolement du système (2) d'alimentation en courant,
**caractérisé par**
la détection d'une tension de déplacement entre le conducteur (12) actif ou un conducteur actif différent du système (2) d'alimentation en courant et la terre (14) sur un côté d'entrée du convertisseur (4) au moyen d'un dispositif de détection (16),
le filtrage d'une partie de signal à fréquence de commutation, générée par le convertisseur (4), à partir de la tension de déplacement détectée au moyen d'un circuit de filtrage passe-haut RC analogique ou d'un circuit numérique de traitement de signal,
l'évaluation de la partie de signal filtrée à fréquence de commutation,
le déclenchement d'un signal de commutation si l'évaluation de la partie de signal à fréquence de commutation montre que la partie de signal à fréquence de commutation dépasse une valeur d'amplitude critique.

2. Procédé selon la revendication 1,
**caractérisé par**
la séparation du convertisseur (4) du système (2) d'alimentation en courant en cas de déclenchement du signal de commutateur.

3. Arrangement de circuit électrique pour une surveillance d'isolement résistant aux interférences d'un système (2) d'alimentation en courant non mis à la terre ayant un convertisseur (4), comportant un dispositif de couplage (8) pour appliquer une tension de mesure entre un conducteur (12) actif du système (2) d'alimentation en courant et la terre (14) et pour détecter un signal de mesure entraîné par la tension de mesure afin de déterminer une résistance d'isolement du système (2) d'alimentation en courant, **caractérisé par**
un dispositif de détection (16) pour l'application d'une tension de mesure entre un conducteur (12) actif ou un conducteur actif différent du système (2) d'alimentation en courant et la terre (14) sur un côté d'entrée du convertisseur (4) et pour le filtrage d'une partie de signal à fréquence de commutation, générée par le convertisseur (4), à partir de la tension de déplacement détectée ; et par un circuit d'évaluation (18) pour l'évaluation de la partie de signal filtrée à fréquence de commutation et pour le déclenchement d'un signal de commutation si l'évaluation de la partie de signal à fréquence de commutation montre que la partie de signal à fréquence de commutation dépasse une valeur d'amplitude critique, le dispositif de détection (16) étant réalisé comme circuit de filtre passe-haut RC analogique ou ayant un circuit numérique de traitement de signal pour filtrer le signal de la partie à fréquence de commutation.

4. Arrangement de circuit électrique selon la revendication 3,
**caractérisé par**
un dispositif de séparation (22) connecté au circuit d'évaluation (18) à l'intermédiaire d'une ligne de signal (20) pour transmettre le signal de commutateur.

5. Dispositif à surveillance d'isolement pour la surveillance d'une résistance d'isolement dans un système (2) d'alimentation en courant non mis à la terre ayant un convertisseur (4),
**caractérisé par**
un dispositif électrique de circuit pour une surveillance d'isolement résistant aux interférences selon la revendication 3 ou la revendication 4.
